# FASCICULE DE BREVET EUROPEEN

(11) **EP 2 673 137 B1**
(45) Date de publication et mention de la délivrance du brevet: **01.03.2017**
(21) Numéro de dépôt: 12704864.3
(22) Date de dépôt: 12.01.2012
(51) Int. Cl.: B32B 27/06, B32B 27/08, B32B 27/32, H01L 31/048, C08G 81/02

(54) **ENCAPSULANT D'UN MODULE PHOTOVOLTAÏQUE**
EINBETTUNGSMATERIAL EINES PHOTOVOLTAIKMODULS
ENCAPSULANT OF A PHOTOVOLTAIC MODULE

(30) Priorité: 11.02.2011 FR 1151110
(43) Date de publication de la demande: 18.12.2013
(73) Titulaire: Arkema France, 92700 Colombes (FR)
(72) Inventeur: BIZET, Stéphane, F-27170 Barc (FR); DEVISME, Samuel, F-76000 Rouen (FR); FINE, Thomas, F-69007 Lyon (FR); JOUSSET, Dominique, F-78380 Bougival (FR)
(74) Mandataire: Gavin, Pablo
(86) Numéro de dépôt international: PCT/FR2012/050083
(87) Numéro de publication internationale: WO 2012/107655

(56) Documents cités:
- EP-A2- 0 939 441
- WO-A-02/28959
- WO-A-2008/043958
- WO-A1-2009/138679
- FR-A- 2 882 060

## Description

### Domaine de l'invention

L'invention a pour objet un encapsulant de module photovoltaïque présentant une structure coeur-peau particulière lui conférant des propriétés optimums pour cette application. La présente invention concerne également un module photovoltaïque, ou son utilisation dans un tel module, comprenant, outre la couche d'encapsulant, au moins une couche adjacente formant « frontsheet » ou « backsheet », plus généralement ces trois couches successives, « frontsheet », encapsulant et « backsheet ».

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques. Un module photovoltaïque comprend une « pile photovoltaïque », cette pile étant capable de transformer l'énergie lumineuse en électricité.

Il existe de nombreux types de structures de panneaux photovoltaïques.

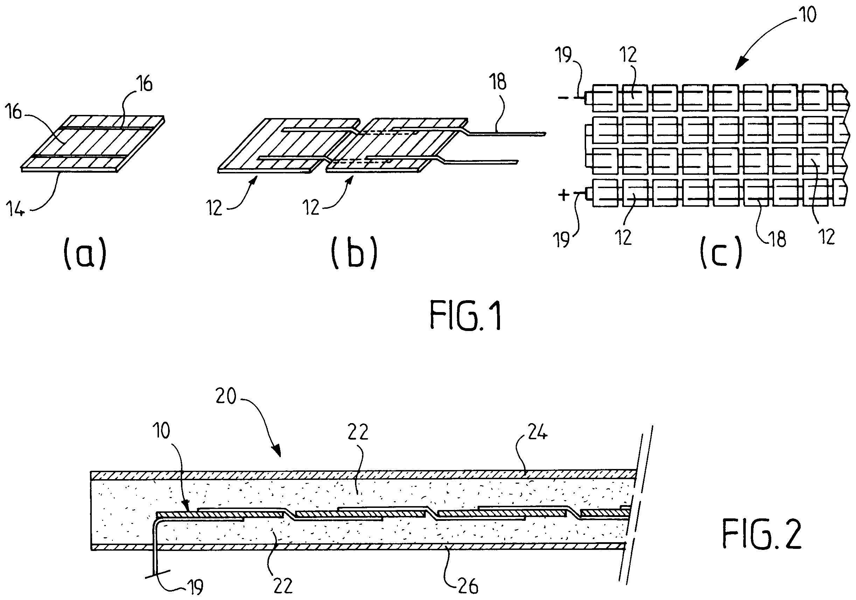

Sur la Figure 1, on a représenté une pile photovoltaïque classique ; cette pile photovoltaïque 10 comprend des cellules 12, une cellule contenant un capteur photovoltaïque 14, généralement à base de silicium traité afin d'obtenir des propriétés photoélectriques, en contact avec des collecteurs d'électrons 16 placés au-dessus (collecteurs supérieurs) et au-dessous (collecteurs inférieurs) du capteur photovoltaïque. Les collecteurs 16 supérieurs d'une cellule sont reliés aux collecteurs 16 inférieurs d'une autre cellule 12 par des barres conductrices 18, constituées généralement d'un alliage de métaux. Toutes ces cellules 12 sont connectées entre elles, en série et/ou en parallèle, pour former la pile photovoltaïque 10. Lorsque la pile photovoltaïque 10 est placée sous une source lumineuse, elle délivre un courant électrique continu, qui peut être récupéré aux bornes 19 de la pile 10.

En référence à la Figure 2, le module photovoltaïque 20 comprend la pile photovoltaïque 10 de la Figure 1 enrobée dans un « encapsulant », celui-ci étant composé d'une partie supérieure 22 et d'une partie inférieure 23. Une couche protectrice supérieure 24 (connue en anglais sous le terme « frontsheet », utilisé dans la suite) et une couche protectrice au dos du module (connue en anglais sous le terme « backsheet », également utilisé dans la suite) 26 sont disposées de part et d'autre la pile encapsulée.

La protection au choc et à l'humidité de la pile photovoltaïque 10 est assurée par la couche protectrice supérieure 24, généralement en verre.

Le backsheet 26, par exemple un film multicouche à base de polymère fluoré et de polyéthylène téréphtalate, contribue à la protection à l'humidité du module photovoltaïque 20 et à l'isolation électrique des cellules 12 pour éviter tout contact avec l'environnement extérieur.

L'encapsulant 22 doit épouser parfaitement la forme de l'espace existant entre la pile photovoltaïque 10 et les couches protectrices 24 et 26 afin d'éviter la présence d'air, ce qui limiterait le rendement du module photovoltaïque. L'encapsulant 22 doit également empêcher le contact des cellules 12 avec l'eau et l'oxygène de l'air, afin d'en limiter la corrosion. La partie supérieure de l'encapsulant 22 est comprise entre la pile 10 et la couche protectrice supérieure 24. La partie inférieure de l'encapsulant 22 est comprise entre la pile 10 et le backsheet 26.

En présence de rayonnement solaire, il se crée un échauffement à l'intérieur du module solaire et des températures de 80°C (ou plus) peuvent être atteintes ce qui nécessite que les couches soient parfaitement liées les unes aux autres tout au long du cycle de vie du module.

### Etat de l'art

D'une manière générale du fait d'une imperméabilité à la vapeur d'eau insuffisante de l'encapsulant, on est obligé d'y adjoindre deux couches, disposées de part et d'autre de cette couche d'encapsulant et formant le « frontsheet » et le « backsheet » (constituant alors un module photovoltaïque sous forme d'un tri-couches avec la couche d'encapsulant comme couche centrale, prise en sandwich entre les deux autres couches), ces dernières présentant des propriétés particulièrement intéressantes en particulier relativement aux propriétés d'imperméabilité à l'eau.

On connaît à l'heure actuelle par le document WO 09138679 une composition thermoplastique constituant l'encapsulant présentant des propriétés particulièrement intéressantes, liées à leurs nanostructurations, à savoir une bonne transparence, une bonne tenue au fluage, des propriétés mécaniques très satisfaisantes et une facilité de mise en oeuvre. Cependant, les compositions thermoplastiques pour lesquelles le tronc polyoléfine possède un point de fusion élevé, peuvent présenter une adhésion insuffisante sur différents substrats notamment en milieu humide ou lors d'un cyclage thermique. Les substrats en question peuvent être d'autres revêtements thermoplastiques ou le verre.

Afin de palier à cet inconvénient, on associe la couche d'encapsulant aux couches de « frontsheet » et « backsheet » par des techniques chimiques (ajout d'un liant assurant la jonction de deux couches) ou physico-chimique (traitement de surface, par exemple de type Corona) mais ces deux méthodes ne sont pas satisfaisantes car elles consistent, outre un coût additionnel non négligeable (matériau, outils spécifiques, temps de réalisation), en une opération parfois complexe pour un résultat souvent décevant.

### Brève description de l'invention

Il a été constaté par la demanderesse, après diverses expériences et manipulations, qu'une structure particulière de l'encapsulant pouvait seule permettre de remédier aux problèmes de cet encapsulant de modules photovoltaïques de l'art antérieur tout en conservant l'ensemble de leurs excellentes propriétés.

Il a en effet été démontré après de multiples expérimentations qu'une variation relativement minime du polymère greffé polyamide connue de la demanderesse (WO 09138679) était capable non seulement de conserver ses propriétés mécaniques mais également de présenter en particulier des propriétés d'adhésion indispensable pour sa fixation aux couches « backsheet » et « frontsheet », étant noté que le polymère greffé polyamide du document susvisé est incapable de se fixer correctement (résultats aux tests de pelage très mauvais) aux matériaux habituels formant « backsheet » et « frontsheet » et notamment ceux présentés dans la présente demande.

Ainsi, la présente invention concerne un encapsulant de module photovoltaïque, destiné à venir enrober une pile photovoltaïque, comprenant deux couches adjacentes thermoplastiques formant un ensemble coeur-peau, caractérisé en ce que :
- la couche de coeur consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
   - le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
   - le reste du monomère insaturé (X) est fixé sur le tronc par greffage ou copolymérisation ;
- la couche de peau consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
   - le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
   - le reste du monomère insaturé (X) est fixé sur le tronc par greffage ou copolymérisation,
   - le tronc en polyoléfine et le greffon en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine.

D'autres caractéristiques de l'invention sont présentées ci-après :
- la couche de peau et la couche de coeur sont nanostructurée ;
- pour la couche de coeur comme pour la couche de peau, la masse molaire en nombre de greffon polyamide est comprise dans la gamme allant de 1000 à 5000 g/mol, de préférence comprise dans la gamme allant de 2000 à 3000 g.mol-1 ;
- pour la couche de coeur comme pour la couche de peau, le nombre de monomère (X) fixé sur le tronc en polyoléfine est supérieur ou égal à 1,3 et/ou inférieur ou égal à 10;
- le tronc en polyoléfine et le greffon en polyamide de la couche de coeur sont choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine ;
- pour la couche de coeur comme pour la couche de peau, le au moins un greffon en polyamide comprend au moins un copolyamide ;
- pour la couche de coeur, le tronc en polyoléfine a une température de fusion supérieure ou égale à 95°C ;
- pour la couche de peau, le tronc en polyoléfine n'a pas de température de fusion ou a une température de fusion inférieure à 95°C ;
- le tronc en polyoléfine et le greffon en polyamide de la couche de coeur sont choisis pour que ledit polymère greffé polyamide présente une température d'écoulement supérieure à 160°C, cette température d'écoulement étant définie comme la température la plus élevée parmi les températures de fusion et les températures de transition vitreuse du greffon polyamide et du tronc en polyoléfine ;
- l'encapsulant selon l'invention consiste en deux couches adjacentes formant un ensemble coeur-peau ou en trois couches adjacentes formant un ensemble peau-coeur-peau où les deux couches de peau entourent la couche de coeur et sont de préférence identiques.

L'invention se rapporte également à l'utilisation de l'encapsulant tel que décrit ci-dessus dans un module photovoltaïque.

Enfin, l'invention se rapporte à un module photovoltaïque comprenant une structure constituée d'une association d'au moins un encapsulant et un frontsheet ou backsheet, caractérisé en ce que l'encapsulant est tel que décrit ci-dessus.

### Description des Figures annexées

La description qui va suivre est donnée uniquement à titre illustratif et non limitatif en référence aux figures annexées, dans lesquelles :
La Figure 1, déjà décrite, représente un exemple de pile photovoltaïque, les parties (a) et (b) étant des vues de ¾, la partie (a) montrant une cellule avant connexion et la partie (b) une vue après connexion de 2 cellules ; la partie (c) est une vue de dessus d'une pile photovoltaïque complète.
La Figure 2, déjà décrite, représente une coupe transversale d'un module photovoltaïque, dont le capteur photovoltaïque « classique » est encapsulé par un film d'encapsulant supérieur et un film d'encapsulant inférieur.

### Description détaillée de l'invention

### I. Couche de coeur de l'encapsulant :

Concernant tout d'abord la couche de coeur de l'encapsulant, elle consiste ici en une couche qui peut se présenter sous deux formes distinctes issues néanmoins d'une même famille de composés. Les caractéristiques communes à ceux types de molécules, appartenant à la même famille de composés, s'énoncent comme suit :
Il s'agit en effet dans les deux cas d'un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
   - le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
   - le reste du monomère insaturé (X) est fixé sur le tronc par greffage ou copolymérisation.

Outre ces caractéristiques communes aux types possibles de molécules formant le coeur de l'encapsulant, la couche de coeur pourra comprendre un certains nombres de composants destinés à conférer des propriétés particulières additionnelles et/ou à améliorer les propriétés intrinsèques du matériau formant l'essentiel de la couche de coeur de l'encapsulant.

Des plastifiants pourront être ajoutés afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des promoteurs d'adhésion, bien que non nécessaires, peuvent être avantageusement ajoutés afin d'améliorer le pouvoir d'adhérence de la composition lorsque celui-ci doit être particulièrement élevé. Le promoteur d'adhésion est un ingrédient non polymérique ; il peut être organique, cristallin, minéral et plus préférentiellement semi-minéral semi-organique. Parmi ceux-ci, on peut citer les titanates ou les silanes organiques, comme par exemple les monoalkyl titanates, les trichlorosilanes et les trialkoxysilanes, les trialcooxysilane. Avantageusement, on utilisera les trialcooxysilanes contenant un groupement époxy, vinyle et amine.

Dans cette application particulière de la composition aux modules photovoltaïques, le rayonnement UV étant susceptible d'entraîner un léger jaunissement de la composition utilisée en tant qu'encapsulant desdits modules, des stabilisants UV et des absorbeurs UV tels que le benzotriazole, le benzophénone et les autres amines encombrés, peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

On pourra également ajouter des anti-oxydants pour limiter le jaunissement lors de la fabrication de l'encapsulant tels que les composés phosphorés (phosphonites et/ou phosphites) et les phénoliques encombrés. On peut ajouter ces anti-oxydants dans des quantités inférieures à 10% en masse de la masse totale de la composition et préférentiellement de 0,1 à 5%.

Des agents retardateurs de flamme peuvent également être ajoutés. Ces agents peuvent être halogénés ou non-halogénés. Parmi les agents halogénés, on peut citer les produits bromés. On peut également utiliser comme agent non-halogéné les additifs à base de phosphore tels que le phosphate d'ammonium, de polyphosphate, de phosphinate ou de pyrophosphate, le cyanurate de mélamine, le pentaérythritol, les zéolithes ainsi que les mélanges de ces agents. La composition peut comprendre ces agents dans des proportions allant de 3 à 40% par rapport à la masse totale de la composition.

On peut également ajouter des pigments comme par exemple le dioxyde de titane, des composés colorants ou azurants dans des proportions allant généralement de 5 à 15% par rapport à la masse totale de la composition.

Des charges, en particulier minérales, peuvent également être ajoutées pour améliorer la tenue thermomécanique de la composition. De façon non limitative, on donnera comme exemples la silice, l'alumine ou les carbonates de calcium ou les nanotubes de carbone ou encore les fibres de verre. On pourra utiliser des argiles modifiées ou non modifiées qui sont mélangées à l'ordre nanométrique ; ceci permet d'obtenir une composition plus transparente.

### I.a) Caractéristiques communes aux deux types de molécules formant la couche de coeur de l'encapsulant selon l'invention :

Dans la suite, il est donc précisé les caractéristiques qui sont communes aux deux types de molécules susceptibles de former le coeur de l'encapsulant selon l'invention, puis dans un deuxième temps (I.b.1 et I.b.2) nous préciserons les caractéristiques spécifiques à chacune de ces molécules.

Ainsi, il est décrit ci-après d'abord ce qui est entendu par la définition de la polyoléfine puis par la définition relative au polymère greffé.

S'agissant du tronc polyoléfine relativement à la partie peau, c'est un polymère comprenant comme monomère une α-oléfine. Egalement, la suite s'entend également en relation avec la partie coeur de l'encapsulant lorsque le comonomère du copolymère est une alpha-oléfine.

On préfère les α-oléfines ayant de 2 à 30 atomes de carbone.

A titre d'α-oléfine, on peut citer l'éthylène, le propylène, 1-butène, 1-pentène, 3-méthyl-1-butène, 1-hexène, 4-méthyl-1-pentène, 3-méthyl-1-pentène, 1-octène, 1-décène, 1-dodécène, 1-tétradécène, 1-hexadécène, 1-octadécène, 1-eicocène, 1-dococène, 1-tétracocène, 1-hexacocène, 1-octacocène, et 1-triacontène.

On peut également citer les cyclo-oléfines ayant de 3 à 30 atomes de carbone, préférentiellement de 3 à 20 atomes de carbone, tels que le cyclopentane, le cycloheptène, le norbornène, le 5-méthyl-2-norbomène, le tétracyclododécène, et le 2-méthyl-1,4,5,8-diméthano-1,2,3,4,4a,5,8,8a-octahydronaphthalène ; di et polyoléfines, telles que la butadiène, l'isoprène, le 4-méthyl-1,3-pentadiène, le 1,4-pentadiène, 1,5-hexadiène, 1,3-hexadiène, 1,3-octadiène, 1,4-octadiène, 1,5-octadiène, 1,6-octadiène, l'éthylidènenorbomène, le vinyle norbornène, le dicyclopentadiène, le 7-méthyl-1,6-octadiène, le 4-éthylidiène-8-méthyl-1,7-nonadiène, et le 5,9-diméthyl-1,4,8-décatriène ; les composés vinyliques aromatiques tels que le mono- ou poly alkylstyrènes (comprenant le styrène, o-méthylstyrène, m-méthylstyrène, p-méthylstyrène, o,p-diméthylstyrène, o-éthylstyrène, m-éthylstyrène et p-éthylstyrène), et les dérivés comprenant des groupes fonctionnels tels que le méthoxystyrène, l'éthoxystyrène, l'acide benzoïque vinylique, le benzoate de méthyle vinyle, l'acétate de benzyle vinyle, l'hydroxystyrène, l'o-chlorostyrène, le p-chlorostyrène, le di-vinyle benzène, le 3-phénylpropène, le 4-phénylpropène, le α-méthylstyrène, le vinyle chloride, le 1,2-difluoroéthylène, le 1,2-dichloroéthylène, le tétrafluoroéthylène, et le 3,3,3-trifluoro-1-propène.

Dans le cadre de la présente invention, le terme d'α-oléfine comprend également le styrène. On préfère le propylène et tout spécialement l'éthylène comme α-oléfine.

Cette polyoléfine peut-être un homopolymère lorsqu'une seule α-oléfine est polymérisée dans la chaîne polymère. On peut citer comme exemples le polyéthylène (PE) ou le polypropylène (PP).

Cette polyoléfine peut aussi être un copolymère lorsqu'au moins deux comonomères sont copolymérisés dans la chaîne polymère, l'un des deux comonomères dit le « premier comonomère » étant une α-oléfine et l'autre comonomère, dit « deuxième comonomère », est un monomère capable de polymériser avec le premier monomère.

A titre de deuxième comonomère, on peut citer :
- une des α-oléfines déjà citées, celle-ci étant différente du premier comonomère α-oléfine,
- les diènes tels que par exemple le 1,4-hexadiène, l'éthylidène norbornène, le butadiène
- les esters d'acides carboxyliques insaturés tels que par exemple les acrylates d'alkyle ou les méthacrylates d'alkyle regroupés sous le terme (méth)acrylates d'alkyles. Les chaînes alkyles de ces (méth)acrylates peuvent avoir jusqu'à 30 atomes de carbone. On peut citer comme chaînes alkyles le méthyle, l'éthyle, le propyl, n-butyl, sec-butyl, Isobutyl, tert-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl, nonacosyl. On préfère les (méth)acrylates de méthyle, éthyle et butyle comme esters d'acide carboxylique insaturés.
- les esters vinyliques d'acide carboxyliques. A titre d'exemples d'esters vinyliques d'acide carboxylique, on peut citer l'acétate de vinyle, le versatate de vinyle, le propionate de vinyle, le butyrate de vinyle, ou le maléate de vinyle. On préfère l'acétate de vinyle comme ester vinylique d'acide carboxylique.

Avantageusement, le tronc en polyoléfine comprend au moins 50 % en moles du premier comonomère ; sa densité peut être avantageusement comprise entre 0,91 et 0,96.

Les troncs polyoléfines préférés sont constitués d'un copolymère éthylène-(méth)acrylate d'alkyle. En utilisant ce tronc polyoléfine, on obtient une excellente tenue au vieillissement à la lumière et à la température.

On ne sortirait pas du cadre de l'invention si différents « deuxièmes comonomères » étaient copolymérisés dans le tronc polyoléfine.

Selon la présente invention, le tronc polyoléfine contient au moins un reste de monomère insaturé (X) pouvant réagir sur une fonction acide et/ou amine du greffon polyamide par une réaction de condensation. Selon la définition de l'invention, le monomère insaturé (X) n'est pas un « deuxième comonomère ».

Comme monomère insaturé (X) compris sur le tronc polyoléfine, on peut citer :
- les époxydes insaturés. Parmi ceux-ci, ce sont par exemple les esters et éthers de glycidyle aliphatiques tels que l'allylglycidyléther, le vinylglycidyléther, le maléate et l'itaconate de glycidyle, l'acrylate et le méthacrylate de glycidyle. Ce sont aussi par exemple les esters et éthers de glycidyle alicycliques tels que le 2-cyclohexène-1-glycidyléther, le cyclohexène-4,5-diglycidylcarboxylate, le cyclohexène-4-glycidyl carboxylate, le 5-norbornène-2-méthyl-2-glycidyl carboxylate et l'endocis-bicyclo(2,2,1)-5-heptène-2,3-diglycidyl dicarboxylate. On préfère utiliser le méthacrylate de glycidyle comme époxyde insaturé.
- les acides carboxyliques insaturés et leurs sels, par exemple l'acide acrylique ou l'acide méthacrylique et les sels de ces mêmes acides.
- les anhydrides d'acide carboxylique. Ils peuvent être choisis par exemple parmi les anhydrides maléique, itaconique, citraconique, allylsuccinique, cyclohex-4-ène-1,2-dicarboxylique, 4-méthylènecyclohex-4-ène-1,2-dicarboxylique, bicyclo(2,2,1)hept-5-ène-2,3-dicarboxylique, et x-méthylbicyclo(2,2,1)hept-5-ène-2,2-dicarboxylique. On préfère utiliser l'anhydride maléique comme anhydride d'acide carboxylique.

Le monomère insaturé (X) est de préférence choisi parmi un anhydride d'acide carboxylique insaturé et un époxyde insaturé. En particulier, pour réaliser la condensation du greffon polyamide avec le tronc polyoléfine, dans le cas où l'extrémité réactive du greffon en polyamide est une fonction acide carboxylique, le monomère insaturé (X) est préférentiellement un époxyde insaturé. Dans le cas où l'extrémité réactive du greffon en polyamide est une fonction amine, le monomère insaturé (X) est avantageusement un époxyde insaturé et préférentiellement un anhydride d'acide carboxylique insaturé.

Selon une version avantageuse de l'invention, le nombre préféré de monomère insaturé (X) fixé en moyenne sur le tronc polyoléfine est supérieur ou égal à 1,3 et/ou préférentiellement inférieur ou égal à 10.

Ainsi, si (X) est l'anhydride maléique et la masse molaire en nombre de la polyoléfine est 15 000 g/mol, on a trouvé que ceci correspondait à une proportion d'anhydride d'au moins 0,8 % en masse de l'ensemble du tronc de polyoléfine et d'au plus 6,5%. Ces valeurs associées à la masse des greffons polyamide déterminent la proportion de polyamide et de tronc dans le polymère greffé polyamide.

Le tronc polyoléfine contenant le reste du monomère insaturé (X) est obtenu par polymérisation des monomères (premier comonomère, deuxième comonomère éventuel, et éventuellement monomère insaturé (X)). On peut réaliser cette polymérisation par un procédé radicalaire à haute pression ou un procédé en solution, en réacteur autoclave ou tubulaire, ces procédés et réacteurs étant bien connus de l'homme du métier. Lorsque le monomère insaturé (X) n'est pas copolymérisé dans le tronc polyoléfine, il est greffé sur le tronc polyoléfine. Le greffage est également une opération connue en soi. La composition serait conforme à l'invention si plusieurs monomères fonctionnels (X) différents étaient copolymérisés et/ou greffés sur le tronc polyoléfine.

Selon les types et ratio de monomères, le tronc polyoléfine peut être semi-cristallin ou amorphe. Dans le cas des polyoléfines amorphes, seule la température de transition vitreuse est observée, tandis que dans celui des polyoléfines semi-cristallins une température de transition vitreuse et une température de fusion (qui sera nécessairement supérieure) sont observées. Il suffira à l'homme du métier de sélectionner les ratios de monomère et les masses moléculaires du tronc polyoléfine pour pouvoir obtenir pouvoir obtenir aisément les valeurs voulues de température de transition vitreuse, éventuellement de température de fusion ainsi que de viscosité du tronc polyoléfine.

De manière préférée, la polyoléfine a un Melt Flow Index (MFI) compris entre 3 et 400g/10min (190°C, 2,16kg, ASTM D 1238).

Les greffons polyamide peuvent être soit des homopolyamides, soit des copolyamides.

Sont notamment visés par l'expression "greffons polyamides" les homopolyamides aliphatiques qui résultent de la polycondensation :
- d'un lactame,
- ou d'un acide alpha,omega-aminocarboxylique aliphatique,
- ou d'une diamine aliphatique et d'un diacide aliphatique.

A titre d'exemples de lactame, on peut citer le caprolactame, l'oenantholactame et le lauryllactame.

A titre d'exemples d'acide alpha,omega-aminocarboxylique aliphatique, on peut citer l'acide aminocaproïque, l'acide amino-7-heptanoïque, l'acide amino-11-undécanoïque et l'acide amino-12-dodécanoïque.

A titre d'exemples de diamine aliphatique, on peut citer l'hexa-méthylènediamine, la dodécaméthylènediamine et la triméthylhexaméthylène diamine.

A titre d'exemples de diacide aliphatique, on peut citer les acides adipique, azélaïque, subérique, sébacique et dodécanedicarboxylique.

Parmi les homopolyamides aliphatiques, on peut citer, à titre d'exemple et de façon non limitative, les polyamides suivants : le polycaprolactame (PA6) ; le polyundécanamide (PA11, commercialisé par ARKEMA sous la marque Rilsan^{®}) ; le polylauryllactame (PA12, également commercialisé par ARKEMA sous la marque Rilsan^{®}) ; le polybutylène adipamide (PA4.6) ; le polyhexaméthylène adipamide (PA6.6) ; le polyhexaméthylène azélamide (PA6.9) ; le polyhexaméthylène sébaçamide (PA-6.10) ; le polyhexaméthylène dodécanamide (PA6.12) ; le polydécaméthylène dodécanamide (PA10.12) ; le polydécaméthylène sébaçanamide (PA10.10) et le polydodecaméthylène dodécanamide (PA12.12).

Sont également visés par l'expression "polyamides semi-cristallins" les homopolyamides cycloaliphatiques.

On peut notamment citer les homopolyamides cycloaliphatiques qui résultent de la condensation d'une diamine cycloaliphatique et d'un diacide aliphatique.

A titre d'exemple de diamine cycloaliphatique, on peut citer la 4,4'-méthylene-bis(cyclohexylamine), encore dénommée para-bis(aminocyclo-hexyl)méthane ou PACM, la 2,2'-diméthyl-4,4'méthylène-bis(cyclo-hexyl-amine), encore dénommée bis-(3-méthyl-4-aminocyclohexyl)-méthane ou BMACM.

Ainsi, parmi les homopolyamides cycloaliphatiques, on peut citer les polyamides PACM.12, résultant de la condensation du PACM avec le diacide en C12, les BMACM.10 et BMACM.12 résultant de la condensation de la BMACM avec, respectivement, les diacides aliphatiques en C10 et en C12.

Sont également visés par l'expression "greffons polyamide" les homopolyamides semi-aromatiques qui résultent de la condensation :
- d'une diamine aliphatique et d'un diacide aromatique, tel que l'acide téréphtalique (T) et l'acide isophtalique (I). Les polyamides obtenus sont alors couramment appelés "polyphtalamides" ou PPA ;
- d'une diamine aromatique, telle que la xylylènediamine, et plus particulièrement la métaxylylènediamine (MXD) et d'un diacide aliphatique.

Ainsi, et de manière non limitative, on peut citer les polyamides 6.T, 6.I, MXD.6 ou encore MXD.10.

Les greffons polyamide rentrant enjeu dans la composition selon l'invention sont préférentiellement des copolyamides. Ceux-ci résultent de la polycondensation d'au moins deux des groupes de monomères énoncés ci-dessus pour l'obtention d'homopolyamides. Le terme « monomère » dans la présente description des copolyamides doit être pris au sens d' « unité répétitive ». En effet, le cas où une unité répétitive du PA est constituée de l'association d'un diacide avec une diamine est particulier. On considère que c'est l'association d'une diamine et d'un diacide, c'est-à-dire le couple diamine-diacide (en quantité équimolaire), qui correspond au monomère. Ceci s'explique par le fait qu'individuellement, le diacide ou la diamine n'est qu'une unité structurale, qui ne suffit pas à elle seule à polymériser pour donner un polyamide.

Ainsi, les copolyamides couvrent notamment les produits de condensation :
- d'au moins deux lactames,
- d'au moins deux acides alpha,omega-aminocarboxyliques aliphatiques,
- d'au moins un lactame et d'au moins un acide alpha,omega-aminocarboxylique aliphatique,
- d'au moins deux diamines et d'au moins deux diacides,
- d'au moins un lactame avec au moins une diamine et au moins un diacide,
- d'au moins un acide alpha,omega-aminocarboxylique aliphatique avec au moins une diamine et au moins un diacide,
la(les) diamine(s) et le(s) diacide(s) pouvant être, indépendamment l'un de l'autre, aliphatiques, cycloaliphatiques ou aromatiques.

Selon les types et ratio de monomères, les copolyamides peuvent être semi-cristallins ou amorphes. Dans le cas des copolyamides amorphes, seule la température de transition vitreuse est observée, tandis que dans celui des copolyamides semi-cristallins une température de transition vitreuse et une température de fusion (qui sera nécessairement supérieure) sont observées.

Parmi les copolyamides amorphes que l'on peut utiliser dans le cadre de l'invention, on peut citer par exemple les copolyamides contenant des monomères semi-aromatiques.

Parmi les copolyamides, on pourra également utiliser les copolyamides semi-cristallins et particulièrement ceux de type PA 6/11, PA6/12 et PA6/11/12.

Le degré de polymérisation peut varier dans de larges proportions, selon sa valeur c'est un polyamide ou un oligomère de polyamide.

Avantageusement, les greffons polyamide sont monofonctionnels.

Pour que le greffon polyamide ait une terminaison monoamine, il suffit d'utiliser un limiteur de chaîne de formule : 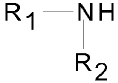 dans laquelle :
- R1 est l'hydrogène ou un groupement alkyle linéaire ou ramifié contenant jusqu'à 20 atomes de carbone,
- R2 est un groupement ayant jusqu'à 20 atomes de carbone alkyle ou alcényle linéaire ou ramifié, un radical cycloaliphatique saturé ou non, un radical aromatique ou une combinaison des précédents. Le limiteur peut être, par exemple, la laurylamine ou l'oleylamine.

Pour que le greffon polyamide ait une terminaison monoacide carboxylique, il suffit d'utiliser un limiteur de chaîne de formule R'1-COOH, R'1-CO-O-CO-R'2 ou un diacide carboxylique.

R'1 et R'2 sont des groupements alkyles linéaires ou ramifiés contenant jusqu'à 20 atomes de carbone.

Avantageusement, le greffon polyamide possède une extrémité à fonctionnalité amine. Les limiteurs monofonctionnels de polymérisation préférés sont la laurylamine et l'oléylamine.

Avantageusement, les greffons polyamide ont une masse molaire comprise entre 1000 et 5000 g/mol et de préférence entre 2000 et 3000 g/mol.

La polycondensation définie ci-dessus s'effectue selon les procédés habituellement connus, par exemple à une température comprise en général entre 200 et 300°C, sous vide ou sous atmosphère inerte, avec agitation du mélange réactionnel. La longueur de chaîne moyenne du greffon est déterminée par le rapport molaire initial entre le monomère polycondensable ou le lactame et le limiteur mono fonctionnel de polymérisation. Pour le calcul de la longueur de chaîne moyenne, on compte habituellement une molécule de limiteur de chaîne pour une chaîne de greffon.

Il suffira à l'homme du métier de sélectionner les types et ratio de monomères ainsi que choisir les masses molaires des greffons polyamide pour pouvoir obtenir aisément les valeurs voulues de température de transition vitreuse, éventuellement de température de fusion ainsi que de viscosité du greffon polyamide.

La réaction de condensation du greffon polyamide sur le tronc de polyoléfine contenant le reste de (X) s'effectue par réaction d'une fonction amine ou acide du greffon polyamide sur le reste de (X). Avantageusement, on utilise des greffons polyamide monoamine et on crée des liaisons amides ou imides en faisant réagir la fonction amine sur la fonction du reste de (X).

On réalise cette condensation de préférence à l'état fondu. Pour fabriquer la composition selon l'invention, on peut utiliser les techniques classiques de malaxage et/ou d'extrusion. Les composants de la composition sont ainsi mélangés pour former un compound qui pourra éventuellement être granulé en sortie de filière. Avantageusement, des agents de couplage sont ajoutés lors du compoundage.

Pour obtenir une composition nanostructurée, on peut ainsi mélanger le greffon polyamide et le tronc dans une extrudeuse, à une température généralement comprise entre 200 et 300 °C. Le temps de séjour moyen de la matière fondue dans l'extrudeuse peut être compris entre 5 secondes et 5 minutes, et de préférence entre 20 secondes et 1 minute. Le rendement de cette réaction de condensation est évalué par extraction sélective des greffons de polyamide libres, c'est-à-dire ceux qui n'ont pas réagi pour former le polymère greffé polyamide.

La préparation de greffons polyamide à extrémité amine ainsi que leur addition sur un tronc de polyoléfine contenant le reste de (X) est décrite dans les brevets US3976720, US3963799, US5342886 et FR2291225.

Le polymère greffé polyamide de la présente invention présente avantageusement une organisation nanostructurée. Pour obtenir ce type d'organisation, on utilisera préférentiellement par exemple des greffons présentant une masse molaire en nombre Mₙ comprise entre 1000 et 5000g/mol et plus préférentiellement entre 2000 et 3000 g/mol.

### I.b.1. Caractéristiques propres au premier type de molécule formant la couche de

### coeur de l'encapsulant selon l'invention :

En sus des caractéristiques communes, ce premier type de molécule envisagée pour former la couche de coeur de l'encapsulant se définit par ailleurs par le fait que le tronc en polyoléfine et le greffon en polyamide sont choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine.

En outre, le tronc en polyoléfine a une température de fusion supérieure ou égale à 95°C.

La température d'écoulement du polymère greffé polyamide est définie comme la température la plus élevée parmi les températures de fusion et les températures de transition vitreuse des greffons polyamides et du tronc polyoléfine.

On utilisera également préférentiellement 15 à 30% en masse de greffons polyamide et un nombre de monomères (X) compris entre 1,3 et 10.

### I.b.2. Caractéristiques propres au second type de molécule formant la couche de coeur de l'encapsulant selon l'invention :

On utilisera dans ce cas 15 à 50% en masse de greffons polyamide et un nombre de monomères (X) compris entre 1,3 et 10.

Pour ce second type de molécule formant la couche de coeur de l'encapsulant selon l'invention, outre les caractéristiques communes énoncées précédemment, le tronc et les greffons sont choisis pour que la température d'écoulement du polymère greffé polyamide soit supérieure à 160°C, ce qui permet une température de mise en oeuvre particulièrement bien adaptée aux techniques actuelles de fabrication de panneaux solaires.

### II. La couche de peau de l'encapsulant :

La composition de la couche de peau est identique à ce qui est présenté au I concernant la couche de coeur, au point I.a) relativement aux « caractéristiques communes » pour ladite couche de coeur et au point I.b.1. concernant l'un des modes de réalisation de la couche de coeur avec néanmoins une différence importante en ce que, pour la couche de peau, le tronc en polyoléfine n'a pas de température de fusion ou a une température de fusion inférieure à 95°C.

### Réticulation/préparation de l'encapsulant et production d'un film encapsulant selon l'invention (destiné à être incorporé dans un module photovoltaïque) :

Concernant l'encapsulant, bien qu'une réticulation ne soit pas obligatoire, celle-ci est possible pour encore améliorer les propriétés thermomécaniques de l'encapsulant, en particulier lorsque la température devient très élevée. On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation. Cette réticulation peut être effectuée par l'une des nombreuses méthodes connues de l'homme du métier, notamment par l'utilisation d'initiateurs activés thermiquement, par exemple des composés peroxydes et azo, des photoinitiateurs tels que le benzophénone, par des techniques de radiation comportant des rayons lumineux, des rayons UV, des faisceaux d'électrons et des rayons X, du silane vinyle tel que par exemple le silane vinyle tri-éthoxy ou tri-méthoxy, et de la réticulation par voie humide. Le manuel intitulé « Handbook of polymer foams and technology » supra, aux pages 198 à 204, fournit des enseignements complémentaires auxquels l'homme du métier peut se référer.

Concernant les aspects de l'invention relatifs à l'utilisation de la composition thermoplastique dans un module photovoltaïque, l'Homme de l'Art peut se référer par exemple au Handbook of Photovoltaic Science and Engineering, Wiley, 2003. En effet, la composition de l'invention peut être utilisée en tant qu'encapsulant ou encapsulant-backsheet dans un module photovoltaïque, dont on décrit la structure en relation avec les figures annexées.

### Matériaux employés pour former les formulations testées :

### Apolhya Solar^{®} LC3UV:

La famille Apolhya Solar^{®} est une famille de polymères commercialisée par ARKEMA qui allient les propriétés des polyamides à celles des polyoléfines grâce à l'obtention de morphologies co-continues à l'échelle manométrique. L'Apolhya Solar^{®} LC3UV est un des grades de la famille Apolhya Solar^{®} qui se caractérise par un MFI (« Melt Flow Index ») de 10 grammes/10 minutes à 230°C sous 2,16 kg commercialisé par la demanderesse. Ce produit présente un module élastique de 65 MPa à température ambiante et le point de fusion du tronc polyoléfine est de 85°C.

### Apolhya^{®} LC4UV:

L'Apolhya Solar^{®} LC4UV est un des grades de la famille Apolhya Solar^{®} qui se caractérise par un MFI (« Melt Flow Index ») de 35 grammes/10 minutes à 190°C sous 2,16 kg commercialisé par la demanderesse. Ce produit présente un module élastique de 130 MPa à température ambiante et le point de fusion du tronc polyoléfine est de 105°C.

**Apolhya^{®} LP91H3 :** La famille Apolhya^{®} est une famille de polymères commercialisée par ARKEMA qui allient les propriétés des polyamides à celles des polyoléfines grâce à l'obtention de morphologies co-continues à l'échelle manométrique. Dans le cadre des tests, il est retenu ici l'Apolhya^{®} LP91H3 qui est un des grades de la famille Apolhya^{®} adapté pour à l'utilisation comme backsheet. Ce grade se caractérise par un MFI (« Melt Flow Index ») de 3,0 grammes/10 minutes à 230°C sous 2,16 kg (AE) et une température de fusion de 220°C..

### Obtention des films et formulations testées :

### Cas des structures LC3UV/LC4UV/LC3UV

Des films multicouches ont été réalisés par calandrage sur une ligne d'extrusion de marque AMUT^{®}. Cette ligne se compose de deux extrudeuses :
- Amut^{®} (70mm*33D) équipée d'une vis barrière
- Stork (40mm*24D) équipée d'une vis degazeuse

La ligne est également équipée d'un bloc de coextrusion fixe (« fixed feedblock ») avec des jeux de cassettes afin de changer facilement de structures, et d'une filière porte manteaux de 650 mm (« coat hanger die »). Un système de filtration équipe l'extrudeuse principale. Le bloc de coextrusion autorise la production d'un film trois couches (Couche 1 / Couche 2 / Couche 3) avec une distribution d'épaisseurs variables (10%/80%/10%). A titre d'exemple non limitatif, on pourra envisager que les paramètres procédés ont été fixés de la façon suivante :
- T° (température) extrusion couche 1 et 3 : 150°C
- T° extrusion couche 2 : 150°C
- T° de la boite de coextrusion et filière : 150°C
- T° cylindres 1, 2 et 3 = 50, 50, 35
- la vitesse de ligne est de 3 m/mn (mètre par minute)
- entrefer filière fixé à 800 microns
- épaisseur totale : 400 microns (50/300/50)

L'homme du métier trouvera facilement dans la littérature un schéma de fonctionnement de la ligne afin d'illustrer la répartition des couches et le suivi du passage de la feuille sur les cylindres.

### Cas des structures LC3UV / LP91H3/LC3UV

Les films multicouches ont été réalisés par extrusion de film à plat (CAST) sur une ligne d'extrusion de marque Dr COLLIN. Cette ligne se compose de 3 extrudeuses équipées d'un profil de vis standard polyoléfine, d'un bloc de coextrusion variable (variable « feedblock »), et d'une filière porte manteaux de 250mm (« coat hanger die »). Le bloc de coextrusion autorise la production d'un film 3 couches (Couche 1 / Couche 2, Couche 3) avec une distribution d'épaisseurs variable s(ex : 50/300/50 microns). Dans le cas particulier et non exhaustif des exemples présentés dans les brevets, les paramètres procédés ont été fixés:
- T° extrusion couche 1 et 3 : 180°C
- T° extrusion couche 2 : 240°C selon les polymères à extruder
- T° boite de coextrusion et filière : 220°C
- la vitesse de ligne est de 2,6 m/mn

Le film final est découpé pour obtenir une laize utile de 100 cm afin de tenir compte du phénomène important d'encapsulation.

### Tests réalisés sur les éprouvettes :

### Test d'adhésion sur une couche de verre :

L'adhésion sur verre a été évaluée selon le protocole suivant. Une structure Verre/film encapsulant/Backsheet est laminée 15 minutes à 150°C à l'aide du laminateur de la société Penergy^{®}. L'épaisseur du film encapsulant est de 400µm Le backsheet est du KPE (Kynar/PET/EVA). L'adhésion à l'interface verre/encapsulant est évaluée à partir d'un test de pelage à 90° effectué à 100 mm/min sur un dynamomètre Zwyck 1445. La largeur du bras de pelage est de 15 mm (millimètre). La force de pelage est exprimée en N/15 mm (Newton par 15 minutes).

Des tests sur l'encapsulant ont également été réalisés pour vérifier que cette nouvelle structure conserve d'excellentes propriétés, c'est-à-dire des propriétés identiques, relativement aux propriétés d'un encapsulant conforme à celui décrit dans le document WO 09138679, à savoir notamment concernant sa transparence, ses propriétés mécaniques, thermomécaniques, ignifuges et ses propriétés d'isolation électrique. Ces test se sont révélés positifs.

Les compositions selon l'invention remplissent donc les critères pour pouvoir être très avantageusement utilisée comme liant ou encapsulant dans les modules solaires.

Les exemples de composition selon l'invention présentent tous les mêmes épaisseurs concernant la couche de peau et celle de coeur mais il est bien entendu que l'homme du métier pourra les faire varier en fonction de l'application du module photovoltaïque et des performances de ce dernier au regard des propriétés intrinsèques de la couche et de celle de coeur, nonobstant la synergie réalisée entre ces deux couches formant l'encapsulant.

La présente invention est illustrée plus en détail par les exemples non limitatif suivant.
Exemple 1 : Le film est un tricouche de 400µm constitué de deux couches externes d'Apolhya Solar^{®} LC3-UV de 50 µm (micromètre) chacune et d'une couche centrale de 300 µm d'Apolhya Solar^{®} LC4-UV.
Exemple 2 : Le film est un tricouche de 400 µm constitué de deux couches externes d'Apolhya Solar^{®} LC3-UV de 50 µm chacune et d'une couche de coeur de 300 µm d'Apolhya^{®} LP91H3.
Exemple comparatif 1 : Le film est un monocouche de 400µm constitué d'Apolhya Solar^{®} LC4-UV.
Exemple comparatif 2 : Le film est un monocouche de 400µm constitué d'Apolhya^{®} LP91H3.

**Résultats des tests réalisés sur les éprouvettes des différentes formulations :**

| | | | | **Adhésion** |
|---|---|---|---|---|
| | couche externe (50µm) | couche interne (300µm) | couche externe (50µm) | N/15mm |
| Exemple 1 | LC3-UV | LC4-UV | LC3-UV | >15 |
| Exemple Comparatif 1 | LC4-UV | | | 0 |
| | | | | |
| Exemple 2 | LC3-UV | LP91H3 | LC3-UV | >15 |
| Exemple comparatif 2 | LP91H3 | | | 0 |

## Revendications

1. Encapsulant de module photovoltaïque, destiné à venir enrober une pile photovoltaïque, comprenant deux couches adjacentes thermoplastiques formant un ensemble coeur-peau, **caractérisé en ce que** :
• la couche de coeur consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
- le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
- le reste du monomère insaturé (X) est fixé sur le tronc par greffage ou copolymérisation ;
- le tronc en polyoléfine de la couche de coeur a une température de fusion supérieure ou égale à 95°C ;
• la couche de peau consiste en un polymère greffé polyamide comprenant un tronc en polyoléfine, représentant de 50% à 95% en masse du polymère greffé polyamide, contenant un reste d'au moins un monomère insaturé (X) et au moins un greffon en polyamide, représentant de 5% à 50% en masse dudit polymère greffé polyamide, dans lequel :
- le greffon en polyamide est attaché au tronc en polyoléfine par le reste du monomère insaturé (X) comprenant une fonction capable de réagir par une réaction de condensation avec un polyamide ayant au moins une extrémité amine et/ou au moins une extrémité acide carboxylique,
- le reste du monomère insaturé (X) est fixé sur le tronc par greffage ou copolymérisation,
- le tronc en polyoléfine et le greffon en polyamide étant choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine,
- le tronc en polyoléfine n'a pas de température de fusion ou a une température de fusion inférieure à 95°C.

2. Encapsulant selon la revendication 1, **caractérisé en ce que** la couche de peau et la couche de coeur sont nanostructurée.

3. Encapsulant selon la revendication 1 ou 2, **caractérisé en ce que**, pour la couche de coeur comme pour la couche de peau, la masse molaire en nombre de greffon polyamide est comprise dans la gamme allant de 1000 à 5000 g/mol, de préférence comprise dans la gamme allant de 2000 à 3000 g/mol.

4. Encapsulant selon l'une quelconque des revendications précédentes, **caractérisé en ce que**, pour la couche de coeur comme pour la couche de peau, le nombre de monomère (X) fixé sur le tronc en polyoléfine est supérieur ou égal à 1,3 et/ou inférieur ou égal à 10.

5. Encapsulant selon l'une quelconque des revendications précédentes, **caractérisé en ce que** le tronc en polyoléfine et le greffon en polyamide de la couche de coeur sont choisis pour que ledit polymère greffé polyamide présente une température d'écoulement supérieure ou égale à 75°C et inférieure ou égale à 160°C, cette température d'écoulement étant définie comme la température la plus élevée parmi les températures de fusion et les températures de transition vitreuse du greffon polyamide et du tronc en polyoléfine.

6. Encapsulant selon l'une quelconque des revendications précédentes, **caractérisé en ce que**, pour la couche de coeur comme pour la couche de peau, le au moins un greffon en polyamide comprend au moins un copolyamide.

7. Encapsulant selon l'une quelconque des revendications 1 à 4, **caractérisé en ce que** le tronc en polyoléfine et le greffon en polyamide de la couche de coeur sont choisis pour que ledit polymère greffé polyamide présente une température d'écoulement supérieure à 160°C, cette température d'écoulement étant définie comme la température la plus élevée parmi les températures de fusion et les températures de transition vitreuse du greffon polyamide et du tronc en polyoléfine.

8. Encapsulant selon l'une quelconque des revendications précédentes, **caractérisé en ce qu'**il consiste en deux couches adjacentes formant un ensemble coeur-peau ou en trois couches adjacentes formant un ensemble peau-coeur-peau où les deux couches de peau entourent la couche de coeur et sont de préférence identiques.

9. Utilisation de l'encapsulant selon l'une quelconque des revendications précédentes dans un module photovoltaïque.

10. Module photovoltaïque comprenant une structure constituée d'une association d'au moins un encapsulant et un frontsheet ou un backsheet, **caractérisé en ce que** l'encapsulant est selon l'une quelconque des revendications précédentes.

## Patentansprüche

1. Verkapselungsmittel eines Photovoltaikmoduls, das dazu bestimmt ist, eine photovoltaische Zelle zu umhüllen, zwei benachbarte thermoplastische Schichten umfassend, die eine Gesamtheit Kern-Mantel bilden, **dadurch gekennzeichnet, dass**:
• die Kernschicht aus einem mit Polyamid gepfropften Polymer besteht, das eine Polyolefin-Hauptkette umfasst, welche 50 bis 95 Masse-% des mit Polyamid gepfropften Polymers repräsentiert, und einen Rest wenigstens eines ungesättigten Monomers (X) und wenigstens eine Pfropfeinheit aus Polyamid enthält, die 5 bis 50 Masse-% des mit Polyamid gepfropften Polymers repräsentieren, wobei:
- die Pfropfeinheit aus Polyamid an die Polyolefin-Hauptkette über den Rest des ungesättigten Monomers (X) gebunden ist, der eine funktionelle Gruppe umfasst, die in der Lage ist, in einer Kondensationsreaktion mit einem Polyamid zu reagieren, das wenigstens eine Aminendgruppe und/oder wenigstens eine Carboxylsäureendgruppe aufweist,
- der Rest des ungesättigten Monomers (X) durch Aufpfropfung oder Copolymerisation an der Hauptkette fixiert ist;
- die Polyolefin-Hauptkette der Kernschicht eine Schmelztemperatur aufweist, die höher als oder gleich 95 °C ist;
• die Mantelschicht aus einem mit Polyamid gepfropften Polymer besteht, das eine Polyolefin-Hauptkette umfasst, welche 50 bis 95 Masse-% des mit Polyamid gepfropften Polymers repräsentiert, und einen Rest wenigstens eines ungesättigten Monomers (X) und wenigstens eine Pfropfeinheit aus Polyamid enthält, die 5 bis 50 Masse-% des mit Polyamid gepfropften Polymers repräsentieren, wobei:
- die Pfropfeinheit aus Polyamid an die Polyolefin-Hauptkette über den Rest des ungesättigten Monomers (X) gebunden ist, der eine funktionelle Gruppe umfasst, die in der Lage ist, in einer Kondensationsreaktion mit einem Polyamid zu reagieren das wenigstens eine Aminendgruppe und/oder wenigstens eine Carboxylsäureendgruppe aufweist,
- der Rest des ungesättigten Monomers (X) durch Aufpfropfung oder Copolymerisation an der Hauptkette fixiert ist;
- die Polyolefin-Hauptkette und die Pfropfeinheit aus Polyamid so gewählt sind, dass das mit Polyamid gepfropfte Polymer eine Fließtemperatur aufweist, die höher als oder gleich 75 °C ist und niedriger als oder gleich 160 °C ist, wobei diese Fließtemperatur als die höchste Temperatur von den Schmelztemperaturen und den Glasübergangstemperaturen der Polyamid-Pfropfeinheit und der Polyolefin-Hauptkette definiert ist;
- die Polyolefin-Hauptkette keine Schmelztemperatur aufweist, oder eine Schmelztemperatur aufweist, die niedriger als 95 °C ist.

2. Verkapselungsmittel nach Anspruch 1, **dadurch gekennzeichnet, dass** die Mantelschicht und die Kernschicht nanostrukturiert sind.

3. Verkapselungsmittel nach Anspruch 1 oder 2, **dadurch gekennzeichnet, dass** die zahlengemittelte Molmasse der Polyamid-Pfropfeinheit sowohl für die Kernschicht als auch für die Mantelschicht in dem Bereich von 1000 bis 5000 g/mol liegt, vorzugsweise in dem Bereich von 2000 bis 3000 g/mol.

4. Verkapselungsmittel nach einem der vorhergehenden Ansprüche, **dadurch gekennzeichnet, dass** die Anzahl der Monomere (X), die an der Polyolefin-Hauptkette fixiert ist, sowohl für die Kernschicht als auch für die Mantelschicht größer oder gleich 1,3 und/oder kleiner oder gleich 10 ist.

5. Verkapselungsmittel nach einem der vorhergehenden Ansprüche, **dadurch gekennzeichnet, dass** die Polyolefin-Hauptkette und die Pfropfeinheit aus Polyamid der Kernschicht so gewählt sind, dass das mit Polyamid gepfropfte Polymer eine Fließtemperatur aufweist, die höher als oder gleich 75 °C ist und niedriger als oder gleich 160 °C ist, wobei diese Fließtemperatur als die höchste Temperatur von den Schmelztemperaturen und den Glasübergangstemperaturen der Polyamid-Pfropfeinheit und der Polyolefin-Hauptkette definiert ist.

6. Verkapselungsmittel nach einem der vorhergehenden Ansprüche, **dadurch gekennzeichnet, dass** die wenigstens eine Polyamid-Pfropfeinheit sowohl für die Kernschicht als auch für die Mantelschicht wenigstens ein Copolyamid umfasst.

7. Verkapselungsmittel nach einem der Ansprüche 1 bis 4, **dadurch gekennzeichnet, dass** die Polyolefin-Hauptkette und die Pfropfeinheit aus Polyamid der Kernschicht so gewählt sind, dass das mit Polyamid gepfropfte Polymer eine Fließtemperatur aufweist, die höher als 160 °C ist, wobei diese Fließtemperatur als die höchste Temperatur von den Schmelztemperaturen und den Glasübergangstemperaturen der Polyamid-Pfropfeinheit und der Polyolefin-Hauptkette definiert ist.

8. Verkapselungsmittel nach einem der vorhergehenden Ansprüche, **dadurch gekennzeichnet, dass** es aus zwei benachbarten Schichten besteht, die eine Gesamtheit Kern-Mantel bilden, oder aus drei benachbarten Schichten, die eine Gesamtheit Mantel-Kern-Mantel bilden, wobei die zwei Mantelschichten die Kernschicht umgeben und vorzugsweise identisch sind.

9. Verwendung des Verkapselungsmittels nach einem der vorhergehenden Ansprüche in einem Photovoltaikmodul.

10. Photovoltaikmodul, welches eine Struktur umfasst, die aus einem Verbund wenigstens eines Verkapselungsmittels und eines Frontsheets oder eines Backsheets besteht, **dadurch gekennzeichnet, dass** das Verkapselungsmittel ein Verkapselungsmittel nach einem der vorhergehenden Ansprüche ist.

## Claims

1. Photovoltaic module encapsulant, intended to encase a photovoltaic cell, comprising two adjacent thermoplastic layers forming a core-skin assembly, **characterized in that**:
• the core layer consists of a polyamide graft polymer comprising a polyolefin backbone, representing from 50% to 95% by weight of the polyamide graft polymer, containing a residue of at least one unsaturated monomer (X) and at least one polyamide graft, representing from 5% to 50% by weight of said polyamide graft polymer, wherein:
- the polyamide graft is attached to the polyolefin backbone by the residue of the unsaturated monomer (X) comprising a function capable of reacting via a condensation reaction with a polyamide having at least one amine end group and/or at least one carboxylic acid end group,
- the residue of the unsaturated monomer (X) is attached to the backbone by grafting or copolymerization,
- the polyolefin backbone of the core layer, has a melting temperature of greater than or equal to 95°C;
• the skin layer consists of a polyamide graft polymer comprising a polyolefin backbone, representing from 50% to 95% by weight of the polyamide graft polymer, containing a residue of at least one unsaturated monomer (X) and at least one polyamide graft, representing from 5% to 50% by weight of said polyamide graft polymer, wherein:
- the polyamide graft is attached to the polyolefin backbone by the residue of the unsaturated monomer (X) comprising a function capable of reacting via a condensation reaction with a polyamide having at least one amine end group and/or at least one carboxylic acid end group,
- the residue of the unsaturated monomer (X) is attached to the backbone by grafting or copolymerization,
- the polyolefin backbone and the polyamide graft being chosen so that said polyamide graft polymer has a flow temperature of greater than or equal to 75°C and less than or equal to 160°C, this flow temperature being defined as the highest temperature among the melting temperatures and glass transition temperatures of the polyamide graft and of the polyolefin backbone,
- the polyolefin backbone does not have a melting temperature or has a melting temperature below 95°C.

2. Encapsulant according to Claim 1, **characterized in that** the skin layer and the core layer are nanostructured.

3. Encapsulant according to Claim 1 or 2, **characterized in that**, for the core layer as for the skin layer, the number-average molar mass of polyamide graft is within the range extending from 1000 to 5000 g/mol, preferably within the range extending from 2000 to 3000 g.mol⁻¹.

4. Encapsulant according to any one of the preceding claims, **characterized in that**, for the core layer as for the skin layer, the number of monomers (X) attached to the polyolefin backbone is greater than or equal to 1.3 and/or less than or equal to 10.

5. Encapsulant according to any one of the preceding claims, **characterized in that** the polyolefin backbone and the polyamide graft of the core layer are chosen so that said polyamide graft polymer has a flow temperature of greater than or equal to 75°C and less than or equal to 160°C, this flow temperature being defined as the highest temperature among the melting temperatures and glass transition temperatures of the polyamide graft and of the polyolefin backbone.

6. Encapsulant according to any one of the preceding claims, **characterized in that**, for the core layer as for the skin layer, the at least one polyamide graft comprises at least one copolyamide.

7. Encapsulant according to any one of Claims 1 to 4, **characterized in that** the polyolefin backbone and the polyamide graft of the core layer are chosen so that said polyamide graft polymer has a flow temperature of greater than 160°C, this flow temperature being defined as the highest temperature among the melting temperatures and glass transition temperatures of the polyamide graft and of the polyolefin backbone.

8. Encapsulant according to any one of the preceding claims, **characterized in that** it consists of two adjacent layers that form a core-skin assembly or of three adjacent layers that form a skin-core-skin assembly where the two skin layers surround the core layer and are preferably identical.

9. Use of the encapsulant according to any one of the preceding claims in a photovoltaic module.

10. Photovoltaic module comprising a structure consisting of a combination of at least one encapsulant and a frontsheet or a backsheet, **characterized in that** the encapsulant is according to any one of the preceding claims.
